# EUROPÄISCHE PATENTANMELDUNG

(11) **EP 4 669 034 A1**
(43) Veröffentlichungstag der Anmeldung: **24.12.2025**
(21) Anmeldenummer: 25180635.2
(22) Anmeldetag: 04.06.2025
(51) Int. Cl.: H05K 1/02, B29C 45/14, H03K 17/00, H01H 13/702, H05K 3/28, H05K 3/46

(54) **ELEKTRONISCH FUNKTIONELLE MEHRSCHICHTSTRUKTUR**

(30) Priorität: 18.06.2024 DE 102024205624
(71) Anmelder: AUMOVIO Germany GmbH, 60488 Frankfurt am Main (DE)
(72) Erfinder: Werner, Paul, 1200 Wien (AT); Raab, Alexander, 1200 Wien (AT); Egger, Andreas, 1200 Wien (AT); Gartner, Ulrich, 1200 Wien (AT)
(74) Vertreter: Aumovio Corporation

(57) **Zusammenfassung**

Es wird eine elektronisch funktionelle Mehrschichtstruktur mit einer ersten Folie (1), auf der erste elektrische und/oder elektronische Komponenten (2) auf einer ersten Folienoberfläche angeordnet sind, und mit einer zweiten Folie (3), auf der zweite elektrische und/oder elektronische Komponenten (4) auf einer ersten Folienoberfläche angeordnet sind, beschrieben. Die beiden Folien (1, 3) sind derart aufeinander angeordnet, dass ihre Seiten mit den jeweiligen ersten Folienoberflächen einander zugewandt sind, wobei zwischen den beiden Folien (1, 3) im Bereich der ersten und zweiten elektrischen und/oder elektronischen Komponenten (2, 4) ein Spalt (5) ist.

## Beschreibung

Die Erfindung betrifft eine elektronisch funktionelle Mehrschichtstruktur mit einer ersten Folie, auf der erste elektrische und/oder elektronische Komponenten auf einer ersten Folienoberfläche angeordnet sind, mit einer zweiten Folie, auf der zweite elektrische und/oder elektronische Komponenten auf einer ersten Folienoberfläche angeordnet sind, wobei die beiden Folien derart aufeinander angeordnet sind, dass ihre Seiten mit den jeweiligen ersten Folienoberflächen einander zugewandt sind.

Eine solche elektronisch funktionelle Mehrschichtstruktur ist aus der US 11,416,081 B1 bekannt. Diese umfasst eine flexible, 3D-formbare Substratfolie mit einer ersten Oberfläche, die den Innenteilen der Struktur zugewandt ist, und einer gegenüberliegenden zweiten Oberfläche, die einer Umgebung der Struktur und einem Benutzer darin zugewandt ist, wobei die erste und zweite Oberfläche und das dazwischen liegende verbleibende Material der Substratfolie lokal einen dreidimensionalen Vorsprung definieren, der sich von einer Ebene des umgebenden Substratfolienmaterials erstreckt und aus lokal gestrecktem und geformtem Material der Substratfolie geformt ist und Seitenwände bildet, durch die eine Berührung detektierbar ist. Die auf der Substratfolie vorgesehene Schaltung umfasst eine Anzahl von leitenden Leiterbahnen, Elektroden und/oder Komponenten zum Erkennen von Berührungen an zwei oder mehr der mehreren Seitenwände und mindestens eine Füllschicht auf der Substratfolie, um die Schaltung zumindest teilweise einzubetten.

Es ist also zwischen den beiden Folien eine Spritzgussschicht angeordnet, die zumindest teilweise die ersten elektrischen und/oder elektronischen Komponenten auf der ersten Folie umgibt. Dadurch sind diese einer erhöhten Belastung während des Spritzgussvorgangs ausgesetzt.

Solche elektronisch funktionellen Mehrschichtstrukturen können für Bedienelemente in Fahrzeugen vorteilhaft eingesetzt werden. Der Bauraum für Aufbauten mit beleuchteten Bedien-Elementen im Automotive Bereich (vor allem im Dach-Bereich) wird zunehmend kleiner. Herkömmliche Konzepte mit konventioneller PCB und LEDs, inkl. erforderlicher Lichtschächte für das durch die LEDs abgestrahlte Licht, lassen sich in aktuell vorgesehene Bauräume in einem Fahrzeug zunehmend schlechter integrieren, da sie einen zu großen Bauraum erfordern.

Es besteht aber ein höheres Risiko für Ausfallraten, weil die LEDs und Leiterbahnen direkt dem Spritzdruck ausgesetzt sind. Beim Ausfall einzelner LEDs muss das gesamte Bauteil entsorgt werden.

Es ist die Aufgabe der Erfindung, eine weniger empfindliche Mehrschichtstruktur anzugeben.

Die Aufgabe wird gelöst durch eine elektronisch funktionelle Mehrschichtstruktur mit einer ersten Folie, auf der erste elektrische und/oder elektronische Komponenten auf einer ersten Folienoberfläche angeordnet sind, mit einer zweiten Folie, auf der zweite elektrische und/oder elektronische Komponenten auf einer ersten Folienoberfläche angeordnet sind, wobei die beiden Folien derart aufeinander angeordnet sind, dass ihre Seiten mit den jeweiligen ersten Folienoberflächen einander zugewandt sind, wobei zwischen den beiden Folien im Bereich der ersten und zweiten elektrischen und/oder elektronischen Komponenten ein Luftspalt ist.

Dabei kann die zweite Folienoberfläche der ersten Folie mit einer ersten Spritzgussschicht versehen sein, die laminiert, geklebt oder durch ähnliche Füge- oder Verbindungs-Prozesse hergestellt ist.

Die Mehrschichtstruktur wird also durch einen umspritzten, laminierten, geklebten oder geschäumten Folienaufbau mit haptischer Oberfläche und integrierten LEDs sowie Touch-Funktionen realisiert. Die LEDs werden auf eine Folie geklebt und die Leiterbahnen werden aufgedruckt. Diese LED-Folie bzw. Flex-PCB kann optional von unten umspritzt, laminiert, geklebt, oder geschäumt werden, wobei in vorteilhafter Weise die LEDs und Leiterbahnen keinem Spritzdruck ausgesetzt sind. Die Touch-Flächen werden auf eine weitere Folie oder eine der bestehenden Folien (je nach Materialwahl und Foliendicke) gedruckt, die eine Deck- oder Dekorfolie sein kann, also gedruckte Symbole aufweisen kann, wobei das Dekor zu einer Umgebung zeigt, in der ein Benutzer die haptische Oberfläche bedienen kann. Die gedruckten Symbole können auf die Ober- oder Unterseite gedruckt werden, je nach Präferenz: stromlos sichtbar oder nicht - oder Funktion: sicherheitsrelevant oder nicht.

Die ersten elektrischen und/oder elektronischen Komponenten können also zumindest mit Leiterbahnen und optisch strahlenden Komponenten gebildet sein, während die zweiten elektrischen und/oder elektronischen Komponenten zumindest mit Leiterbahnen und berührungs- oder kontaktempfindlichen Komponenten gebildet sein können.

In einer Weiterbildung der Mehrschichtstruktur ist auf der zweiten Folienoberfläche der zweiten Folie eine dritte Folie angeordnet, deren von der zweiten Folie abgewandte Oberfläche mit gedruckten Symbolen versehen ist.

Dabei kann zwischen der zweiten und der dritten Folie eine zweite Spritzgussschicht (laminiert, geklebt oder ähnliche Füge- oder Verbindungs-Prozesse) angeordnet sein.

Der Bereich zwischen der zweiten Touch-Folie und der dritten optionalen Dekor-Folie kann mittels 2K-Spritzguss (mehrkomponentig laminiert, geklebt oder ähnliche Füge- oder Verbindungs-Prozesse) ausgefüllt sein. Auch hier werden die Leiterbahnen keinem Spritzdruck ausgesetzt, weil diese auf der Bauteil-Außenseite angebracht sind. Die beiden Spritzguss-Elemente, die mit der ersten Folie mit optionaler erster Spritzgussschicht bzw. der zweiten Folie mit optionaler zweiter Spritzgussschicht und optionaler dritter (Dekor-) Folie gebildet sind, werden dann an ihrem Randbereich oder an jeder anderen möglichen Position form- und/ oder kraftschlüssig miteinander verbunden, woraus ein einziges, sehr flaches, Bauteil resultiert.

In vorteilhafter Weise weist bzw. weisen bei einer Ausbildung der Mehrschichtstruktur die zweite Folie und - soweit vorhanden - die zweite Spritzgussschicht im Bereich von auf der ersten Folie angeordneten LEDs mit optisch durchlässigem Material gefüllte Öffnungen für das Licht der LEDs auf. Hierdurch kann das Licht der LEDs auf der ersten Folie durch die Dekorfolie hindurchtreten. Der Einsatz von einfacher und hochwertiger Optik ist möglich mittels Linsen, Streuscheiben, usw..

An der ersten Spritzgussschicht und / oder an der zweiten Spritzgussschicht können in den Luftspalt zwischen den beiden Folien ragende Dome oder Stege angeordnet sein, um eine ausreichende mechanische Festigkeit und Formstabilität zu gewährleisten. Diese Stege oder Dome können auch dazu dienen, Streulicht zwischen den verschiedenen LEDs zu verhindern.

Die erste Spritzgussschicht und die zweite Spritzgussschicht können an ihren Randbereichen eine Verbindung insbesondere in Form von Nieten, die mit einer der Spritzgussschichten gebildet sind, aufweisen.

Durch die erfindungsgemäßen Maßnahmen kann die gesamte Mehrschichtstruktur eine maximale Dicke von wenigen Millimetern haben.

Es ist also durch aufgedruckte Leiterbahnen und geklebte LEDs auf eine Folie sowie aufgedruckte Touch-Flächen auf einer weiteren Folie und das Einbetten der Folien durch rückseitiges Umspritzen, Laminieren, Kleben oder Schäumen eine sehr flache Bauweise von A-Surfaces und die Integration sämtlicher Leucht- und Touch-Funktionen in ein einziges Bauteil möglich.

Durch den rückseitigen-Spritzgussprozess (oder laminiert, geklebt oder ähnliche Füge- oder Verbindungs-Prozesse) unterliegen die Leiterbahnen und LEDs nicht dem Spritzdruck, wodurch das Risiko sowie die daraus resultierenden Kosten für Ausfallraten stark reduziert werden.

Die Ausfallraten können des Weiteren reduziert werden, weil bei defekten LEDs nicht das gesamte umspritzte, laminierte, geklebte, oder geschäumte Bauteil entsorgt werden muss, wenn die Prüfung vor dem Vereinen der beiden Bauteilhälften erfolgen kann und die weiteren Produktionsschritte keinen maßgeblichen Einfluss auf i.O. und n.i.O. Status haben. A-Surface sowie ein LED-Funktions-Bauteil können separat produziert und getestet werden, wodurch die Ausfallraten bei defekten Bauteilen reduziert werden können.

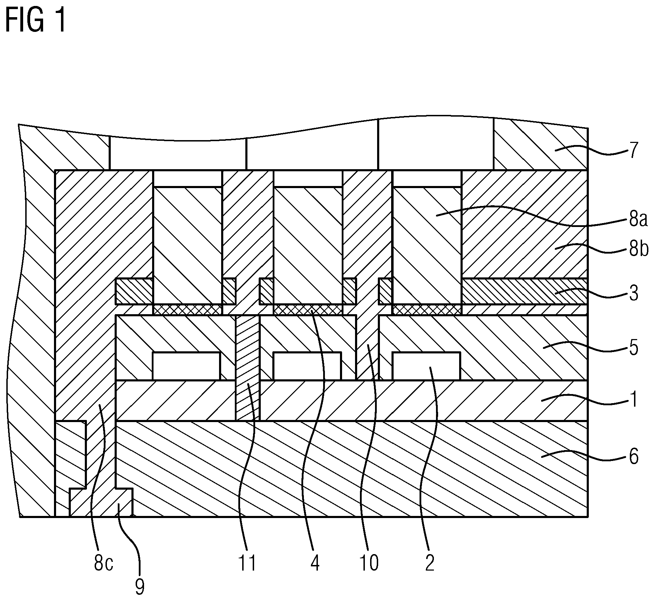

Die Erfindung wird nachfolgend anhand eines Aufführungsbeispiels mit Hilfe einer Figur näher beschrieben. Dabei zeigt die
- Fig. 1: einen Querschnitt durch eine Mehrschichtstruktur mit LEDs und berührungsempfindlichen Elementen.

In der Fig. 1 ist eine erste Folie 1 gezeigt, auf der elektrische und /oder elektronische Komponenten 2 in Form von Leiterbahnen und zumindest LEDs als elektronische Komponenten aufgedruckt bzw. aufgeklebt sind. Diese erste Folie 1 ist auf ihrer der mit den elektrischen und /oder elektronischen Komponenten 2 versehenen Oberfläche abgewandten Oberfläche mit einer ersten Spritzgussschicht 6 versehen. Durch das Anbringen dieser ersten Spritzgussschicht 6 auf dieser zweiten Folienoberfläche sind die elektrischen und /oder elektronischen Komponenten 2 nicht dem Spritzgussdruck ausgesetzt. Trotzdem weist die Folie 1 eine ausreichende Stabilität auf.

Es ist außerdem eine zweite Folie 3 gezeigt, auf der zumindest Leiterbahnen und berührungsempfindliche Bereiche als elektrische und /oder elektronische Komponenten 4, insbesondere im Bereich unter einer zweiten Teilschicht 8b angebracht sind. Diese zweite Folie 3 kann bereits auf ihrer der mit den elektrischen und /oder elektronischen Komponenten 4 versehenen Oberfläche abgewandten Oberfläche mit gedruckten Symbolen und haptisch erkennbaren Druckbereichen versehen sein und somit als Dekorfolie wirken.

In dem Ausführungsbeispiel ist jedoch eine dritte Folie 7 vorgesehen, die diese Dekorfunktion übernimmt. Sie kann direkt mit der zweiten Folie 3 verbunden sein, ist jedoch im Ausführungsbespiel der Figur 1 über eine zweite Spritzgussschicht 8a, 8b mit der zweiten Folie 3 verbunden.

Die zweite Spritzgussschicht 8a, 8b ist dabei mit einer ersten Teilschicht 8a gebildet, die optisch durchlässige Bereiche für das Licht der LEDs auf der ersten Folie 1 bilden. Diese erste Teilschicht 8a ist von einer zweiten Teilschicht 8b umgeben, die die gesamte zweite Spritzgussschicht stützt.

Die LEDs können auch in einem Luftspalt zwischen der zweiten Folie 3 und der ersten Teilschicht 8a platziert werden, wenn die zweite Teilschicht 8b deutlich dünnere Wandstärken als die erste Teilschicht 8a aufweist. Dies führt weiters zu einer flacheren Bauweise.

Die erste Spritzgussschicht 6 weist Dome oder Stege 11 auf, die durch die erste Folie 1 hindurch- und in den Luftspalt 5 hineinragen. In gleicher Weise weist die zweite Spritzgussschicht 8a, 8b weist Dome oder Stege 10 auf, die durch die zweite Folie 3 hindurch- und in den Luftspalt 5 hineinragen. Durch diese Dome oder Stege 10, 11 wird die ganze Mehrschichtstruktur gestützt und verleiht ihr Formstabilität. Außerdem kann durch diese Dome oder Stege 10, 11 Streulicht zwischen den LEDs verhindert werden.

Die beiden Teilstrukturen aus der ersten Folie 1 und der ersten Spritzgussschicht 6 bzw. der zweiten Folie 3, der zweiten Spritzgussschicht 8a, 8b und der dritten Folie 7 können getrennt gefertigt und auch getestet werden.

Sie werden dann mit ihren mit den elektrischen und /oder elektronischen Komponenten 2, 4 versehenen Oberflächen zueinander gewandt zu der Mehrschichtstruktur zusammengefügt. Hierzu kann, wie in der Figur 1 zu erkennen ist, eine Heißnietverbindung 9 dienen, die durch einen Randbereich der ersten Spritzgussschicht 6 hindurch mit der seitlich verlängerten zweiten Teilspritzgussschicht 8c verbunden ist. Auch die dritte Folie 7 kann über die Seiten der Mehrschichtstruktur hinweg angebracht werden, um eine optisch ansprechende Oberfläche, die einem Benutzer zugewandt ist, zu bilden.

## Patentansprüche

1. Elektronisch funktionelle Mehrschichtstruktur
mit einer ersten Folie (1), auf der erste elektrische und/oder elektronische Komponenten (2) auf einer ersten Folienoberfläche angeordnet sind,
mit einer zweiten Folie (3), auf der zweite elektrische und/oder elektronische Komponenten (4) auf einer ersten Folienoberfläche angeordnet sind,
wobei die beiden Folien (1, 3) derart aufeinander angeordnet sind, dass ihre Seiten mit den jeweiligen ersten Folienoberflächen einander zugewandt sind,
**dadurch gekennzeichnet,**
**dass** zwischen den beiden Folien (1, 3) im Bereich der ersten und zweiten elektrischen und/oder elektronischen Komponenten (2, 4) ein Spalt (5) ist.

2. Elektronisch funktionelle Mehrschichtstruktur nach Anspruch 1, **dadurch gekennzeichnet, dass** der Spalt (5) mit einem Gas gefüllt ist.

3. Elektronisch funktionelle Mehrschichtstruktur nach Anspruch 1, **dadurch gekennzeichnet, dass** in dem Spalt (5) Vakuum ist.

4. Elektronisch funktionelle Mehrschichtstruktur nach einem der vorhergehenden Ansprüche, **dadurch gekennzeichnet, dass** die ersten elektrischen und/oder elektronischen Komponenten (2) zumindest mit Leiterbahnen und optisch strahlenden Komponenten gebildet sind.

5. Elektronisch funktionelle Mehrschichtstruktur nach einem der vorhergehenden Ansprüche, **dadurch gekennzeichnet, dass** die zweiten elektrischen und/oder elektronischen Komponenten (4) zumindest mit Leiterbahnen und berührungs- oder kontaktempfindlichen Komponenten gebildet sind.

6. Elektronisch funktionelle Mehrschichtstruktur nach einem der vorhergehenden Ansprüche, **dadurch gekennzeichnet, dass** die zweite Folienoberfläche der ersten Folie (1) mit einer ersten Spritzgussschicht (6) versehen ist.

7. Elektronisch funktionelle Mehrschichtstruktur nach einem der vorhergehenden Ansprüche, **dadurch gekennzeichnet, dass** die zweite Folienoberfläche der zweiten Folie (3) mit gedruckten Symbolen versehen ist.

8. Elektronisch funktionelle Mehrschichtstruktur nach einem der Ansprüche 1 bis 6, **dadurch gekennzeichnet, dass** auf der zweiten Folienoberfläche der zweiten Folie (3) eine dritte Folie (7) angeordnet ist, deren von der zweiten Folie (3) abgewandte Oberfläche mit gedruckten Symbolen versehen ist.

9. Elektronisch funktionelle Mehrschichtstruktur nach Anspruch 8, **dadurch gekennzeichnet, dass** zwischen der zweiten (3) und der dritten Folie (7) eine zweite Spritzgussschicht (8a, 8b) angeordnet ist.

10. Elektronisch funktionelle Mehrschichtstruktur nach einem der vorhergehenden Ansprüche, **dadurch gekennzeichnet, dass** die zweite Folie (3) und - soweit vorhanden - die zweite Spritzgussschicht (8a) im Bereich von auf der ersten Folie (1) angeordneten LEDs mit lichtdurchlässigem Material gefüllte Öffnungen (8b) für das Licht der LEDs aufweist bzw. aufweisen.

11. Elektronisch funktionelle Mehrschichtstruktur nach einem der Ansprüche 6 bis 10, **dadurch gekennzeichnet, dass** an der ersten Spritzgussschicht (6) in den Spalt (5) ragende Dome (11) angeordnet sind.

12. Elektronisch funktionelle Mehrschichtstruktur nach einem der Ansprüche 9 bis 11, **dadurch gekennzeichnet, dass** an der zweiten Spritzgussschicht (8a, 8b) in den Spalt (5) ragende Dome (10) angeordnet sind.

13. Elektronisch funktionelle Mehrschichtstruktur nach einem der Ansprüche 9 bis 11, **dadurch gekennzeichnet, dass** die erste Spritzgussschicht (6) und die zweite Spritzgussschicht (8a, 8b) an ihren Randbereichen (8c) eine Verbindung (9) aufweisen.
